# EUROPEAN PATENT APPLICATION

(11) **EP 4 345 895 A1**
(43) Date of publication of application: **03.04.2024**
(21) Application number: 22198199.6
(22) Date of filing: 27.09.2022
(51) Int. Cl.: H01L 23/538, H05K 3/46

(54) **IC SUBSTRATE WITH EMBEDDED BRIDGE ELEMENT, ARRANGEMENT, AND MANUFACTURE METHOD**

(71) Applicant: AT & S Austria Technologie & Systemtechnik Aktiengesellschaft, 8700 Leoben-Hinterberg (AT)
(72) Inventor: Gavagnin, Marco, 8700 Leoben (AT); Leitgeb, Markus, 8793 Trofaiach (AT)
(74) Representative: Dilg, Haeusler, Schindelmann Patentanwaltsgesellschaft mbH

(57) **Abstract**

There is described an integrated circuit, IC, substrate (100), comprising:
i) a reinforced fiber-free dielectric material (110);
ii) a bridge element (120) comprising:
iia) at least two electrically conductive terminals (121a, 121b),
iib) an electrical interconnection (125) that electrically interconnects the at least two electrically conductive terminals (121a, 121b), and
iic) a dielectric protection material (122) that encapsulates the electrical interconnection (125),
wherein the bridge element (120) is embedded in the reinforced fiber-free dielectric material (110), so that at least two components (140a, 140b), when surface mounted to a first main surface (101) of the IC substrate (100), are electrically connected to the at least two electrically conductive terminals (121a, 121b), respectively; and

iii) a redistribution layer, RDL, structure (130), arranged at a second main surface (102) of the IC substrate (100) being opposite to the first main surface (101), and electrically connectable by further electrical interconnections (105) to the at least two components (140a, 140b).

## Description

### Field of the Invention

The invention relates to an integrated circuit (IC) substrate, an IC substrate arrangement, an electronic assembly, and a method of manufacturing an IC substrate. Further, the invention relates to a use of an organic bridge element in a silicon-free IC substrate.

Accordingly, the invention may relate to the technical field of component carriers, in particular interposers, such as IC substrates.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

There may be a trend in the component carrier industry to mount two or more electronic components onto a circuit board, whereby these electronic components are interconnected through an electric connection, in particular wherein the electric connection is embedded in the circuit board. In other words, instead of embedding the electronic components into the circuit board, only the electric connection between the electronic components is embedded into the circuit board. Such an embedded interconnection may be termed a bridge and is generally provided by copper traces encapsulated in a silicon material.

However, providing a high density patterning (e.g. a very small line/space ratio) in this regard, in particular in an economic manner, may be seen as a challenge.

### Summary of the Invention

There may be a need to provide an IC substrate, in particular an interposer, with a high functionality (and/or a high density) in an efficient and economic manner.

According to an aspect of the invention, there is described an integrated circuit (IC) substrate, in particular a silicon-free IC substrate, comprising:
i) a reinforced fiber-free dielectric material (for example an Ajinomoto build-up film);
ii) a bridge element comprising:
   iia) at least two electrically conductive terminals (exposed at the top surface),
   iib) an electrical interconnection (e.g. traces of electrically conductive material) that electrically interconnects the at least two electrically conductive terminals, and
   iic) a dielectric protection material (in particular an organic dielectric protection material) that encapsulates the electrical interconnection.

The bridge element is at least partially embedded in the reinforced fiber-free dielectric material, so that at least two (active/passive, electric/electronic) components (e.g. integrated circuits), when surface mounted to a first main surface (being parallel to the directions of main extension along the x- and y-axes) of the IC substrate, are electrically connected/connectable to the at least two electrically conductive terminals, respectively.

The IC substrate further comprising:
iii) a redistribution layer (RDL) structure, arranged at a second main surface of the IC substrate (being opposite to the first main surface), and electrically connected/connectable by further electrical interconnections (vias) to the at least two components.

According to a further aspect of the invention, there is described an IC substrate arrangement, comprising:
i) the IC substrate as described above; and
ii) the at least two components surface mounted to the first main surface; wherein the first component is electrically connected to the first terminal of the bridge element, and wherein a second component is electrically connected to the second terminal of the bridge element, so that the at least two components are electrically interconnected by the bridge element.

According to a further aspect of the invention, there is described an electronic assembly comprising:
i) the IC substrate as described above and/or the IC substrate arrangement as described above; and
ii) a component carrier, in particular a printed circuit board or a further IC substrate or an interposer, wherein the IC substrate or the IC substrate arrangement is surface mounted to the component carrier.

According to a further aspect of the invention, there is described a method of manufacturing an integrated circuit substrate, the method comprising:
i) providing a bridge element that comprises at least two electrically conductive terminals, an electrical interconnection that electrically interconnects the at least two electrically conductive terminals, and a dielectric protection material that encapsulates the electrical interconnection;
ii) embedding the bridge-element at least partially in a reinforced fiber-free dielectric material, so that at least two components, when surface mounted to a first main surface of the IC substrate, are electrically connected to the at least two electrically conductive terminals, respectively; and
iii) forming a redistribution layer structure at a second main surface of the IC substrate being opposite to the first main surface, and electrically connectable to at least two components.

According to a further aspect of the invention, there is described a use of (method of using) an organic (silicon-free) bridge element in a (essentially) silicon-free IC substrate (besides embedded components which may comprise silicon), wherein the organic bridge element is embedded in a reinforced fiber-free dielectric material (of the IC substrate).

In the context of the present document, the term "reinforced fiber-free dielectric material" or "reinforced fabric-free dielectric material" may in particular refer to a dielectric material, for example a resin, that is not reinforced (reenforced) by fibers. In the technical field of component carriers, it may be common to apply resins that are reinforced by fibers such as glass fibers or carbon fibers. An important example may be FR4 material that is widely used and comprises an epoxy-resin with embedded fibers. In this respect, a fiber may be a natural or man-made structure that is significantly longer than it is wide. In particular, a fiber may be at least partially flexible/bendable. A "reinforced fiber-free dielectric material" may hence by any dielectric material that is reinforced but not by using fibers. In an example, the reinforced fiber-free dielectric material is reinforced by spheres, e.g. glass spheres. Hence, a preferred example may be Ajinomoto build-up film (ABF) that comprises a resin with embedded glass spheres. Alternatively, the reinforced fiber-free dielectric material may be totally free from any reinforcement structures.

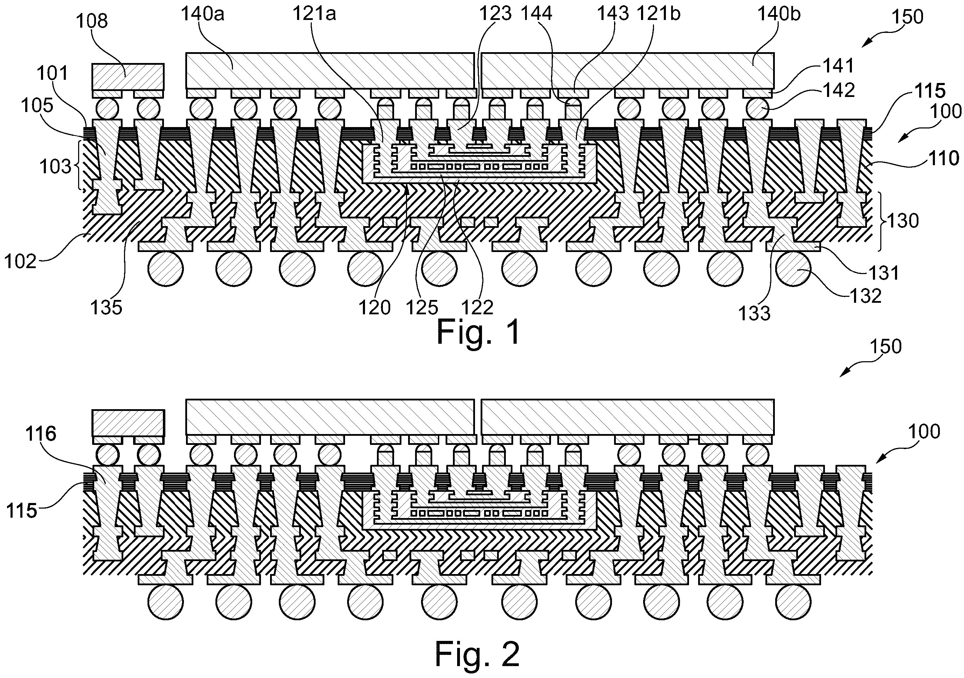

In the context of the present document, the term "bridge element" may in particular refer to any element that may function as an electric interconnection between (active/passive) components, in particular electric/electronic components. In an example, the bridge element may require at least two (exposed) electrically conductive terminals to connect respectively to the components. In a more sophisticated example, the bridge element may comprise a plurality of terminals for (inter-)connecting two or more components. The electrically conductive terminals (preferably these terminals are exposed at the same main surface (top main surface) of the bridge element) may be interconnected by an electrical interconnection arranged in the bridge element. Electrically conductive terminals and electric interconnection may hence be arranged in a "U"-shape, when seen in a (specific) cross-section of the bridge element (for example in a side view cross-section, see e.g. Figure 1). In particular, the bridge element may comprise a plurality of "U"-shapes, whereby a larger "U" surrounds a smaller "U". The (organic) bridge element may include further structures with functionalities beyond the interconnection between ICs, for example resistance measurements, ground, thermal dissipation, etc.

In the context of the present document, the term "dielectric protection material" may in particular refer to a dielectric material suitable to embed/encapsulate the electric interconnection (and optionally at least partially the electrically conductive terminals) of the bridge element, thereby protecting the interconnection. The dielectric protection material may be the same or different compared to dielectric material of the IC substrate (in particular reinforced fiber-free dielectric material), in which the bridge element is (partially) embedded. In a preferred embodiment, the dielectric protection material may consist of or comprise an organic material, for example a resin. In this example, the dielectric protection material may not comprise silicon. In an example, the dielectric protection material may be free of an inorganic material, in particular metal and/or ceramics. Yet, in another example, the dielectric protection material may comprise glass.

In the context of the present document, the term "silicon" may in particular refer to elementary silicon and/or metallic silicon. Even though glass can comprise silicon dioxide (SiO₂), this may not be considered as silicon in the present context. For example, a core layer structure of an IC substrate may be reinforced by glass fibers. Nevertheless, the IC substrate may still be considered as silicon-free as the glass may not contain elementary/metallic silicon.

In the context of the present document, the term "organic bridge element" may in particular refer to the dielectric protection material. This means that, when the dielectric protection material comprises an organic material, the bridge element may be considered as an organic bridge element. The electrically conductive parts of the bridge element (terminals, electric interconnections) may comprise metals such as copper and may in an example not be taken into account, when evaluating if the bridge element is organic or not.

In the context of the present document, the term "redistribution layer (RDL) structure" may in particular refer to an electrically conductive structure that is designed to translate a small electric contact at a first surface to a large electric contact at a second surface, in particular wherein first and second surface are arranged opposed to each other. In an example, the redistribution layer structure comprises a plurality of vertical structures (vias) and horizontal structures (pads) to enlarge the size of a first electric contact (i.e. a terminal of an IC) to the scale of a second electric contact (i.e. a solder ball to be mounted on a larger component carrier entity). In an example, the redistribution layer structure extends through the whole IC substrate. In another example, the redistribution layer structure is arranged below the bridge element in the IC substrate. Yet, the redistribution layer structure may be electrically connected by (comparably long) vias vertically to electric contacts on the (upper) main surface of the IC substrate.

In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate and an IC (integrated circuit) substrate.

In the context of the present document, the term "IC substrate" may particularly denote a small component carrier. An IC substrate may be a, in relation to a PCB, comparably small component carrier onto which one or more components may be mounted and that may act as a connection medium between one or more chip(s) and a further PCB. More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. In an example, an IC substrate may be seen as an interposer, for example between electronic components and a printed circuit board.

In the present context, an IC substrate should not be understood as any substrate suitable to bear an IC. Instead, the term "IC substrate" may be a technically established term for a specific, high density PCB that comprises common PCB materials. A silicon substrate for example may not be considered an IC substrate in the present context.

According to an exemplary embodiment, the invention may be based on the idea that an IC substrate with a high functionality and/or a high density, may be provided in an efficient and economic manner, when both, a bridge element and a redistribution layer structure are integrated in the IC substrate, wherein the bridge element is embedded in a reinforced fiber-free dielectric material. The described IC substrate may be flexibly used in many different applications as a versatile interposer between two or more electronic components and a printed circuit board.

While conventionally interposers may comprise a bridge to interconnect the surface-mounted components or a redistribution layer to connect the surface-mounted components to a larger entity, it has now been found by the inventors, that an especially efficient IC substrate may be obtained, when both functionalities are integrated into one and the same interposer. For example, additional vias may connect the redistribution layer structure to a first part of the component, while a second part is connected to the bridge element. Thereby, a high functionality with different electric connections between components and redistribution layer structure (upper and lower main surface of the IC substrate) may be provided.

In particular, in interplay with the reinforced fiber-free dielectric material, an efficient manufacture method may be enabled that leads to high density patterns. In a preferred example, an organic bridge element may be embedded in a silicon-free IC substrate, thereby saving the costs of silicon material. Further, in this manner, established component carrier (resin-based) techniques may be directly applied, so that the IC substrate may be manufactured in one and the same component carrier manufacture process/facility.

### Exemplary Embodiments

According to an embodiment, the (reinforced fiber-free) dielectric material is reinforced by a spheric(-ally shaped) material, in particular glass spheres or carbon spheres, more in particular wherein the dielectric material comprises an Ajinomoto build-up film, ABF. This may provide the advantage that a robust and established material can be applied to increase the pattern density (in particular line spacing). While fiber-reinforced materials such as prepreg are established in the component carrier industry, the fibers may constitute a plurality of elongation structures that may hamper the manufacture of a high density pattern. Thus, especially in the case of an IC substrate, the application of spheres may be favored over fibers as a filler material. Furthermore, the embedding of the bridge element may be done more efficiently and accurately in a sphere-reinforced resin.

In an example, the adhesion between the described reinforced fiber-free dielectric material and a bridge element (to be embedded therein) may be especially stable, in particular when the bridge element is an organic/silicon-free bridge element. Without wishing to be bound to a specific theory, it is presently believed that an interface between resin materials (of the reinforced fiber-free dielectric material and the dielectric protection material of the bridge element) is more homogenous (e.g. regarding the thermal expansion coefficient) and more robust in comparison to an interface between e.g. resin material and silicon material. Further, the coefficient of thermal expansion (CTE) may be more favorable (better tune-able) and the filling behavior of a cavity may be improved. Thereby, also the formation of comparably smaller vias may be enabled.

According to a further embodiment, the bridge element is (essentially) free of silicon. In other words, the bridge element (in particular it is referred to the dielectric protection material) does (essentially) not comprise silicon or a siliconbased component. This may provide the advantage that costs can be saved (silicon may be rather expansive in comparison to resin material), while the whole manufacture may be performed within a component carrier manufacture plant that applies resins instead of silicon. Further, a resin/resin interface may be more stable and robust than a resin/silicon interface.

According to a further embodiment, the IC substrate itself is (essentially) free of silicon. In other words, the IC substrate comprises essentially metal and a dielectric (resin) material which does not comprise silicon. In an example, in case that an electric component (e.g. a semiconductor) may be embedded in the IC substrate, the potential silicon content of the electric component may not be taken into account, when evaluating if the IC substrate is free of silicon.

According to a further embodiment, the dielectric protection material comprises or consists of an organic material (e.g. carbon-based compounds). In this example, the dielectric protection material may be free of silicon.

According to a further embodiment, the dielectric protection material is different to the reinforced fiber-free dielectric material. For example, the dielectric protection material may be a non-reinforced resin material such as e.g. a photo-imaginable dielectric (PID) material and polyimide. Depending on the desired application, it may be advantageous (e.g. providing a higher flexibility) to have a less reinforced material to encapsulate the electric interconnections of the bridge element.

According to a further embodiment, the dielectric protection material is comparable (i.e. essentially the same), in particular similar (the same), to the reinforced fiber-free dielectric material. Depending on the desired application, it may be advantageous to apply similar materials, thereby e.g. reducing material damage caused by different thermal expansion. Different may be the amount of reenforced fiber-free material respectively.

According to a further embodiment, the IC substrate further comprises a core layer structure in which the bridge element is at least partially embedded. Such a core-layer structure may provide the advantage that the IC substrate may be stabilized, more robust, and prone bump pitch against warpage. In an example, the core layer structure may comprise a cured resin material during the manufacture, while other dielectric layer structures of the IC substrate may not be fully cured during manufacture. In an embodiment, the bridge element may be well protected when embedded in said core layer structure.

In the context of this document, the term "core layer structure" may in particular refer to a fully cured frame (dielectric layer structure), in particular with two electrically conductive layer structures in direct contact with the opposite surface of the dielectric layer structure, respectively.

Additionally or alternatively the core layer structure may comprise a plurality of alternating fully cured frames and a plurality of electrical conductive layer structures sandwiched in stack-thickness direction ("any-layer stack").

According to a further embodiment, the reinforced fiber-free dielectric material forms the core layer structure. Thereby, the bridge element may be directly embedded in the core layer structure, potentially enabling a robust adhesion.

According to a further embodiment, the reinforced fiber-free dielectric material is provided in a further core layer structure, in particular a fiber-enforced dielectric material such as a prepreg. In this example, the reinforced fiber-free dielectric material may be different from the further core layer structure material and may be embedded itself in a well-protected manner in the core. In an example, glass fibers may not taken into account, when considering if the IC substrate is silicon-free or not.

According to a further embodiment, the IC substrate is a coreless (i.e. core layer structure free) IC substrate. This may provide the advantage that the IC substrate can be designed in an especially thin (yet still robust) manner. In an example, manufacturing may include additive processes, e.g. (m)SAP / NIL (nanoimprint lithography). In a further example, NIL may also be applied for manufacturing the bridge element. In this context, the term "NIL" may in particular refer to a method of fabricating nanometer scale patterns. The nanolithography process creates patterns by mechanical deformation of the imprint resist layer and subsequent processes. The imprint resist layer is typically a monomer or polymer formulation that is cured by heat or UV light during or after the imprinting. Adhesion between the resist and the stamp may be controlled to allow proper release.

According to a further embodiment, the further electric interconnections comprises a plurality of vias that at least partially vertically extend through the IC substrate and that are electrically connectable to the components and/or the redistribution layer structure, in particular wherein the bridge element is arranged in between the plurality of vias (in particular in a horizontal direction (parallel to the directions of main extension x, y), more in particular in the middle/center of the IC substrate in a horizontal and/or vertical direction).

In this preferred embodiment both, the bridge element and the RDL structure, may be efficiently embedded in the IC substrate. The embedded bridge element may hereby be surrounded by the further electric (vertical) interconnections ranging from the RDL structure to the surface-mounted components. The vias may form at the same time an efficient electric connection and a protective cage for the embedded bridge element. Such a protective cage may further have a shielding function, e.g. electromagnetic shielding with respect to antennas. Additionally, the protective cage may offer a thermal functionality.

According to a further embodiment, the thickness of the (further) core layer structure is larger than the thickness of the bridge element. This may provide the advantage that the bridge element is encapsulated and protected in a robust manner. The stable material of the (further) core layer structure may support the bridge element from below and from the sides.

According to a further embodiment, the IC substrate further comprises an upper dielectric layer structure on top of the bridge element and the dielectric material. This may provide the advantage that a further build-up may be provided in a flexible manner. The upper dielectric may be similar or different to the reinforced fiber-free dielectric material. Vias may be formed through the upper dielectric material to establish electric through-connections between the components and the bridge element/redistribution layer structure.

In an example, the upper dielectric layer structure comprises a different material as the dielectric material, for example a non-reinforced dielectric material (resin, e.g. a PID or polyimide). In another example, the upper dielectric layer structure may comprise a fiber-reinforced dielectric material.

In an example, the upper dielectric layer structure comprises a comparable/similar material as the dielectric material.

In the context of this document, the term "comparable" may in particular refer to the circumstance that two materials (and/or layer structures) are essentially similar. For example, two reinforced fiber-free layer structures may be comparable, but not similar, when the resin material is different. In another example, two reinforced fiber layer structures may be comparable, when both are reinforced by (glass) fibers but comprise different resin materials. Yet in another example, two reinforced fiber-free layer structures may be comparable, but not similar, when the reinforced fiber-free layer structures differ in the amount of reinforced material respectively.

In an example, the upper dielectric layer structure comprises a plurality of upper dielectric layer structure vias that vertically extend through the upper dielectric layer structure and that are electrically connectable to the components and/or are electrically connected to the plurality of vias (further electric interconnections).

According to a further embodiment, the redistribution layer structure comprises an RDL dielectric material that is different from the dielectric material, in particular a fiber-reinforced dielectric material. According to a further embodiment, the redistribution layer structure comprises an RDL dielectric material that is comparable/similar from the dielectric material.

Depending on the desired application, a similar or a different material may be preferable in different examples.

According to a further embodiment, the IC substrate comprises at least one embedded (electric) component (active or passive). In a preferred example, said component is (at least partially) embedded in the (further) core layer structure, in particular with an upper main surface flush with the (further) core layer structure. This may provide the advantage that a further functionality is well protected. Hereby, the embedded component may be electrically connected by vias at the top and/or bottom main surface.

According to a further embodiment, one or more components is/are embedded at a comparable (in particular the same) vertical level (in the stack) as the bridge element. In an example, the component may be encapsulated in the fiber-free material (e.g. ABF) on the same layer of the bridge element.

According to a further embodiment, the IC arrangement comprises a further (electric) component (active or passive) that is surface mounted to the IC substrate. Said component may be arranged adjacent (side-by-side) with the at least two components. In an example, the further component is electrically not connected to the bridge element. Yet, in a further example, the further component is electrically connected to the bridge element.

According to a further embodiment, the at least two components comprise three or more, in particular four or more components, each of which is electrically connected/connectable to the bridge element (in particular all components are hereby interconnected through the bridge element).

According to a further embodiment, the IC substrate comprises two or more bridge elements. In this example, the at least two components may comprise three or more components (see above).

According to a further embodiment, the method further comprises: placing the bridge element, in particular with a terminal main surface where the terminals are exposed, (directly) on a temporary carrier. A temporary carrier may be an established concept in component carrier manufacturing: a part of the manufacturing may be done on the temporary carrier (e.g. one or more electrically insulating and/or conductive layer structures), and afterwards, the temporary carrier may be removed.

According to a further embodiment, embedding the bridge element further comprises: laminating the dielectric material over the bridge element.

According to a further embodiment, embedding the bridge element further comprises: placing the bridge element in a cavity of a core layer structure and encapsulating the bridge element in the cavity with the dielectric material.

In these embodiments, the bridge element may be mounted (e.g. using an adhesive) on a temporary carrier and/or in a cavity (e.g. using an adhesive) of a stack-preform. The dielectric material may be in an un-cured form, so that the sidewalls of the bridge element may also be covered and protected efficiently.

According to a further embodiment, the method further comprising: forming a plurality of vias through the dielectric material and/or the core layer structure. This may be done by established component carrier manufacture techniques such as mechanical drilling and/or laser drilling.

According to a further embodiment, the method further comprises: forming an upper dielectric layer structure on top of the dielectric material and particularly forming a plurality of upper dielectric layer structure vias through said upper dielectric layer structure.

According to a further embodiment, the IC substrate comprises a layer structure of solder resist and/or surface finish (e.g. ENIPEG).

According to a further embodiment, a plurality of IC substrates may be manufactured (at least partly) simultaneously. Afterwards, a singularization step (e.g. cutting and/or depth routing) may be performed to manufacture separate IC substrates.

According to a further embodiment, the IC substrate is connected to the at least one component and/or to the component carrier by a metal structure, in particular a metal pillar, more in particular a copper pillar.

According to a further embodiment, at least two mounted components comprises a similar or a different bump pitch (for example one of standard flip chip bump, fine-pitch bump, micro-bump, pilar-bump).

In the following, some embodiments of component carriers are described in detail. These descriptions are applicable to IC substrates as well as to printed circuit boards.

In an embodiment, the component carrier is configured as one of a printed circuit board, a substrate (in particular an IC substrate), and an interposer.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier stack comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components and being nevertheless very thin and compact.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, socalled prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (e.g. dielectric material) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure (for example electric interconnection, terminal, pad, via, etc.) comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack.

The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK (milliKelvin). Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Electroless Palladium Autocatalytic Gold).

### Brief Description of the Drawings

The aspects defined above and further aspects of the invention are apparent from the examples of embodiment to be described hereinafter and are explained with reference to these examples of embodiment.
Figures 1 to 4 respectively show IC substrate arrangements according to exemplary embodiments of the invention.
Figure 5 shows an electronic assembly according to an exemplary embodiment of the invention.
Figures 6a to 6e show a method of manufacturing an IC substrate according to an exemplary embodiment of the invention.
Figures 7a to 7f show a method of manufacturing an IC substrate according to a further exemplary embodiment of the invention.
Figures 8a to 8f show a method of manufacturing an IC substrate according to a further exemplary embodiment of the invention.

### Detailed Description of the Drawings

The illustrations in the drawings are schematic. In different drawings, similar or identical elements are provided with the same reference signs.

**Figure 1** shows an integrated circuit (IC) substrate arrangement 150 according to an exemplary embodiment of the invention. The arrangement 150 comprises an IC substrate 100 with two surface mounted components 140a, 140b and a further surface-mounted component 108.

The IC substrate 100 comprises a central layer (may be considered a core layer structure 103) made of a reinforced fiber-free dielectric material 110, in this example an Ajinomoto build-up film with glass spheres embedded in a resin. A bridge element 120 is embedded in said reinforced fiber-free dielectric material 110, so that the top main surface of the bridge element 120 and the top main surface of the reinforced fiber-free dielectric material 110 are flush.

The bridge element 120 comprises a plurality of electrically conductive terminals 121a, 121b, all of which are exposed at the top main surface of the bridge element 120. An electrical interconnection 125 (which comprises a plurality of sub-interconnections) electrically interconnects the electrically conductive terminals 121a, 121b pairwise. Hereby, an organic dielectric protection material 122 encapsulates the electrical interconnection 125. In the present example, the organic dielectric protection material 122 and the reinforced fiber-free dielectric material 110 are illustrated to be different. Nevertheless, the materials 110, 122 can be the same in another example. In the present example, the dielectric protection material 122 comprises a non-reinforced resin such as a photo-imaginable dielectric (PID) material or polyimide.

Two components 140a, 140b, in this example integrated circuits, are surface mounted to a first (upper) main surface 101 of the IC substrate 100 adjacent to each other (i.e. side-by side, not in physical contact but without another structure in between). Each component 140a, 140b is electrically connected to a plurality of electrically conductive terminals 121a, 121b of the bridge element 120.

An upper dielectric layer structure 115 (e.g. ABF layer, PID (photoimageable dielectric) layer, NIL layer) forms the outermost layer of the IC substrate 100, being arranged on the reinforced fiber-free dielectric material 110 and the bridge element 120 (which is flush with the dielectric material 110). The plurality of electrically conductive terminals 121a, 121b of the bridge element 120 are connected through the upper dielectric layer 115 by bridge element vias 123 (here a tapering via and a pillar structure). These vias 123 are further electrically connected to component bridge solder balls 144, which in turn are connected to component bridge terminals 143.

Besides the components 140a, 140b, a further component (active or passive) 108 is surface mounted adjacent to the left component 140a but is not connected to the bridge element 120.

The IC substrate 100 further comprises a redistribution layer structure 130, arranged/exposed at a second main surface 102 of the IC substrate 100 being opposite to the first main surface 101. The redistribution layer structure (RDL) 130 comprises a plurality of RDL pads 131 and a plurality of RDL vias 133, embedded in an RDL dielectric material 135, to translate the scale of a component solder ball 142 (small IC pad) to the scale of an RDL solder ball 132 (large further entity pad). The RDL dielectric material 135 can be the same or different as the reinforced fiber-free dielectric material 110 and/or the bridge element 120.

The IC substrate 100 comprises a plurality of further electrical interconnections 105 (vias) to electrically connect the RDL structure 130 through the reinforced fiber-free dielectric material 110 to the components 140a, 140b, in particular the component solder balls 142. The plurality of vias 105 at least partially vertically extend through the IC substrate 100 and are electrically connected to the components 140a, 140 and the redistribution layer structure 130. The bridge element 120 is arranged hereby in between (in a horizontal direction, in particular in the center of) the plurality of vias 105. The redistribution layer structure 103 comprises an RDL dielectric material 135 that is in this example shown as being different from the dielectric material 110, in particular a fiber-reinforced dielectric material 135.

In this example, the bridge element 120 and the IC substrate 100 itself, are made of organic materials and are free of silicon. The components 140a, 140b, in particular when configured as semiconductor chips, may comprise silicon, but are not considered as part of the IC substrate 100.

The IC substrate 100 further comprises a core layer structure 103 in which the bridge element 120 is fully embedded. In the present example, the reinforced fiber-free dielectric material 110 forms the core layer structure 103. Further, in this example, the thickness of the core layer structure 103 is larger than the thickness of the bridge element 120.

**Figure 2** shows an IC arrangement 150 with an IC substrate 100 according to a further embodiment of the invention. The IC substrate 100 of Figure 2 is very similar to the one shown in Figure 1, yet the upper dielectric layer structure 115 comprises a plurality of upper dielectric layer structure vias 116 that extend from the vias 105 through the upper dielectric layer structure 115. In Figure 1, in contrast, the vias 105 extend through the upper dielectric layer structure 115. This difference reflects different manufacture steps of drilling/filling the vias.

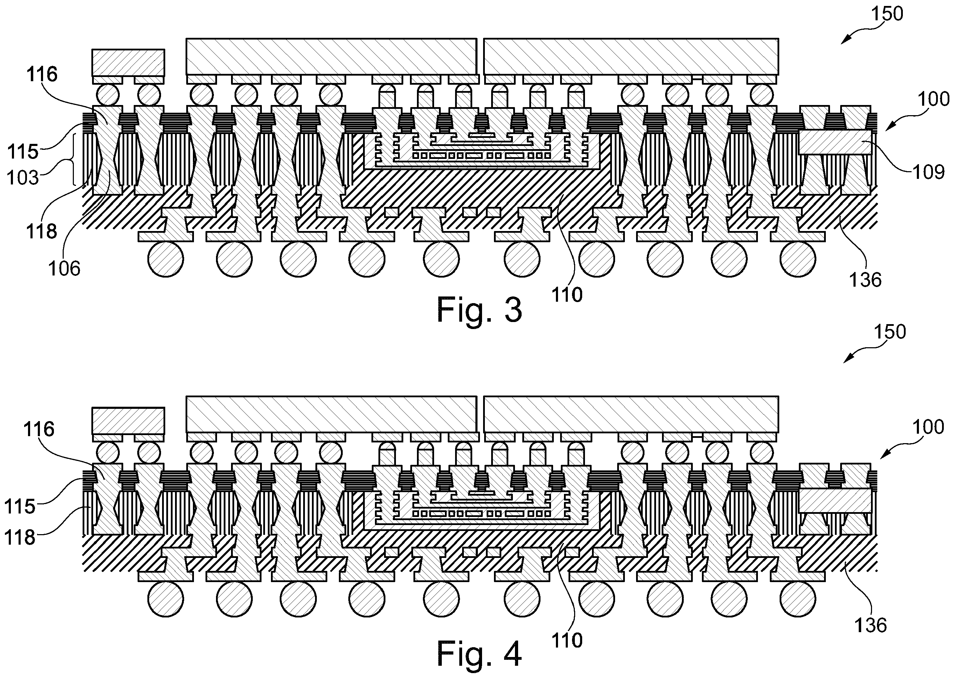

**Figure 3** shows an IC arrangement 150 with an IC substrate 100 according to a further embodiment of the invention. The IC substrate 100 of Figure 3 comprises several features as the one shown in Figure 2, yet there are some structural differences.

In Figure 3, the reinforced fiber-free dielectric material 110 is arranged only in a region around the bridge element 120, thereby surrounding (encapsulating) the bridge element 120. The core layer structure 103 is formed by a further core layer structure 118, being different from the reinforced fiber-free dielectric material 110. In this example, the further core layer structure 118 comprises a (cured or not fully cured) reinforced fiber dielectric material, e.g. a prepreg.

The IC substrate 100 comprises additionally an embedded component 109, embedded in an upper part of the further core layer structure 118 and electrically connected to the upper dielectric layer structure vias 116.

While the vias 105 through the core layer structure 103 are shown in Figures 1 and 2 to taper from top to bottom, in Figure 3, these vias 105 comprise an hourglass-like shape 106. In other words, from top to the middle (vertical center) of the vias 105 taper and from bottom to the middle, the vias 105 taper as well, so that a constriction is formed at the (vertical) center of each via 105.

In this example, the dielectric RDL material 136 is similar (not different 135) to the dielectric protection material 122.

**Figure 4** shows an IC arrangement 150 with an IC substrate 100 according to a further embodiment of the invention. The IC substrate 100 of Figure 4 is very similar to the one shown in Figure 3, yet the core layer structure 118 of Figure 4 is significantly thinner, being just slightly thicker than the bridge element 120.

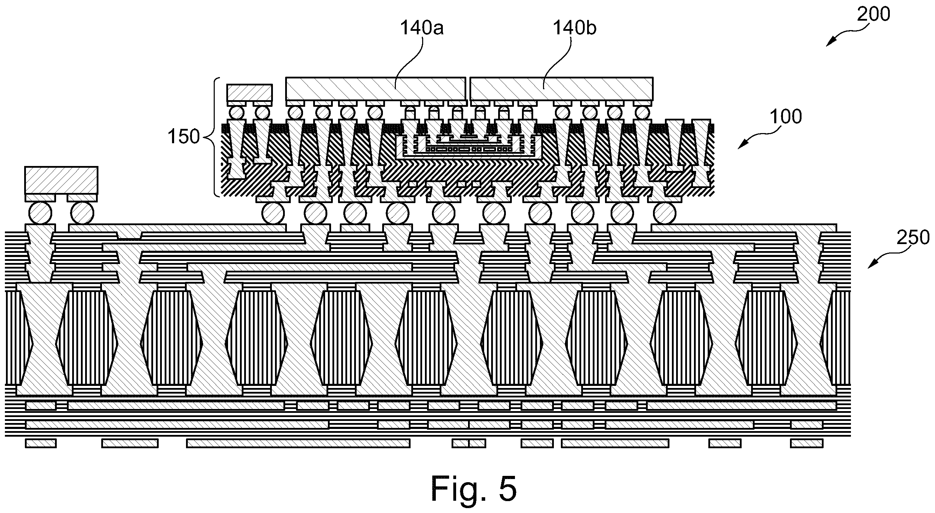

**Figure 5** shows an electronic assembly 200 according to an exemplary embodiment of the invention. The electronic assembly 200 comprises an IC arrangement 150 as described for Figures 1 to 4 above. Further, the electronic assembly 200 comprises an additional component carrier 250 being configured as a printed circuit board, wherein the IC substrate arrangement 150 is surface mounted to the component carrier 250. The IC substrate 100 functions here as an interposer that i) translates the small electric connections of the components 140a, 140b to the large electric pads of the component carrier 250, and ii) interconnects the functionalities of the components 140a, 140b via the bridge element 120.

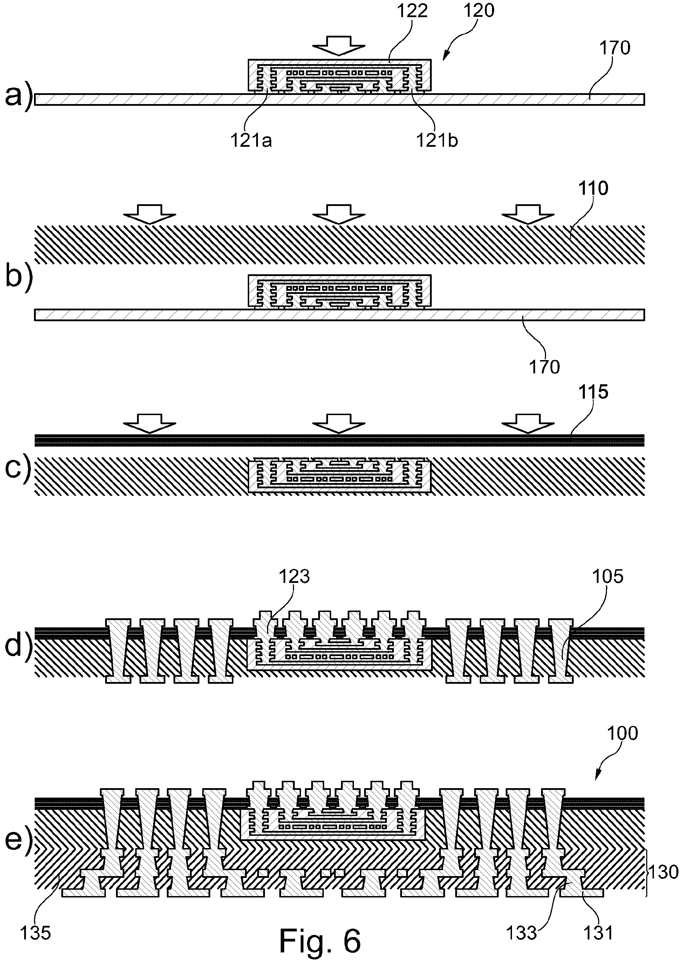

**Figures 6a to 6e** show a method of manufacturing an IC substrate 100 according to an exemplary embodiment of the invention.

Figure 6a: there is provided a temporary carrier 170 onto which the bridge element 120 is arranged/formed. The first bridge terminal 121a and the second bridge terminal 121b are oriented towards the temporary carrier 170 and are in direct physical contact with the later. Said terminals 121a, 121b are electrically interconnected via the electric interconnection 125 in the dielectric protection material 122.

Figure 6b: the reinforced fiber-free dielectric material 110 is provided (in uncured form) on top of the bridge element 120, thereby encapsulating the bridge element 120.

Figure 6c: the encapsulated bridge element 120 is removed from the temporary carrier 170 (and turned around in this example) and is covered (laminated) by an upper dielectric layer structure/material 115 that is arranged on top of the terminals 121a, 121b. The fiber-free dielectric material 110 is flush with the first bridge terminal 121a and the second bridge terminal 121b of the bridge element 120 on the upper main surface.

Figure 6d: vias 105 are formed through the upper dielectric layer structure 115 and the reinforced fiber-free dielectric material 110. This can be done by laser drilling, thereby forming a tapering from the upper main surface to the lower main surface. At the respective main surface, each via 105 is covered by a pad. The first bridge terminal 121a and the second bridge terminal 121b are electrically connected through the upper dielectric layer structure 115 by a plurality of bridge element vias 123 that are respectively elongated (in stack thickness direction) by an additional electrically conductive pillar.

Figure 6e: a redistribution layer structure 130, comprising a plurality of traces 131 and vias 133 in a dielectric material 135, is formed at the bottom of the IC substrate 100, directly below the reinforced fiber-free dielectric material 110, but not in contact with the embedded bridge element 120. The final IC substrate 100 is comparable with the one described for Figure 1.

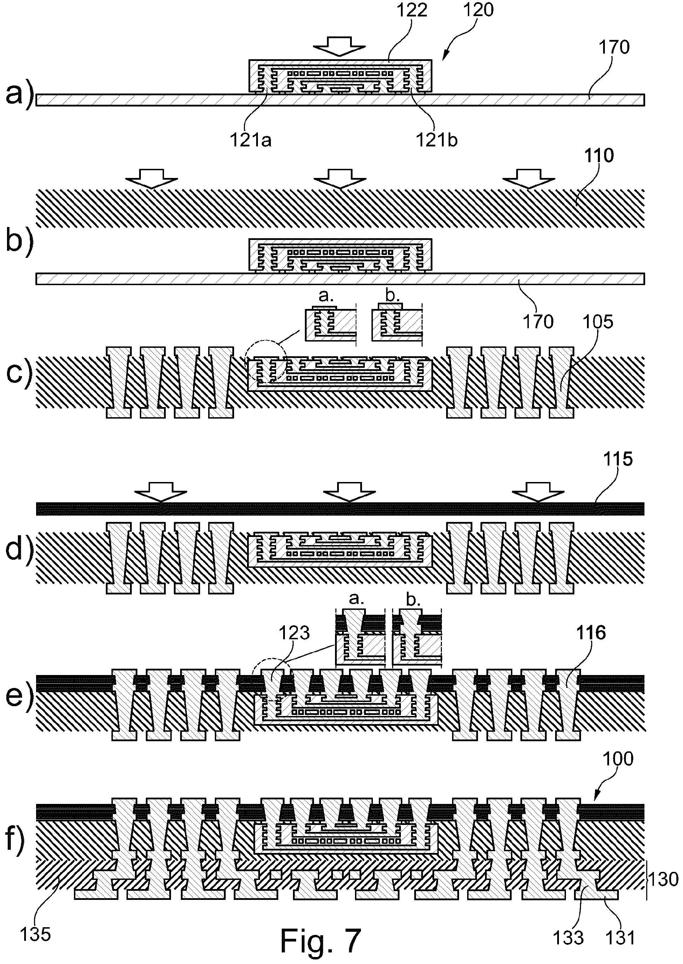

**Figures 7a to 7f** show a method of manufacturing an IC substrate 100 according to a further exemplary embodiment of the invention.

Figure 7a: there is provided a temporary carrier 170 onto which the bridge element 120 is arranged/formed. The first bridge terminal 121a and the second bridge terminal 121b are oriented towards the temporary carrier 170 and are in direct physical contact with the later. Said terminals 121a, 121b are electrically interconnected via the electric interconnection 125 in the dielectric protection material 122.

Figure 7b: the reinforced fiber-free dielectric material 110 is provided (in uncured form) on top of the bridge element 120, thereby encapsulating the bridge element 120.

Figure 7c: the encapsulated bridge element 120 is removed from the temporary carrier 170 (and turned around in this example). Vias 105 are formed through the reinforced fiber-free dielectric material 110. This can be done by laser drilling, thereby forming a tapering from the upper main surface to the lower main surface. At the respective main surface, each via 105 is covered by a pad. Fiber-free dielectric material 110 is flush with connection pads 121a and 121b. Indicated are two additional options (a. and b.), considering that during the plating of the vias around the bridge element 120, the thickness of the exposed pads 121a, 121b can be increased. This might have two positive effects:
i) laser via formation and plating can be more homogeneous with the surrounding area of the bridge element, while the hole geometry is the same;
ii) reduced stress of the bridge element pads 121a, 121b during laser via formation as the metal/copper is thickened.

Figure 7d: the encapsulated bridge element 120 is covered (laminated) by an upper dielectric layer structure 115 that is arranged on top of the terminals 121a, 121b.

Figure 7e: the first bridge terminal 121a and the second bridge terminal 121b are electrically connected through the upper dielectric layer structure 115 by a plurality of bridge element vias 123. Further, the vias 105 are respectively electrically connected through the upper dielectric layer structure 115 by a plurality of upper dielectric layer structure vias 116.

Figure 7f: a redistribution layer structure 130, comprising a plurality of traces 131 and vias 133 in a dielectric material 135, is formed at the bottom of the IC substrate 100, directly below the reinforced fiber-free dielectric material 110, but not in contact with the embedded bridge element 120. The final IC substrate 100 is comparable with the one described for Figure 2.

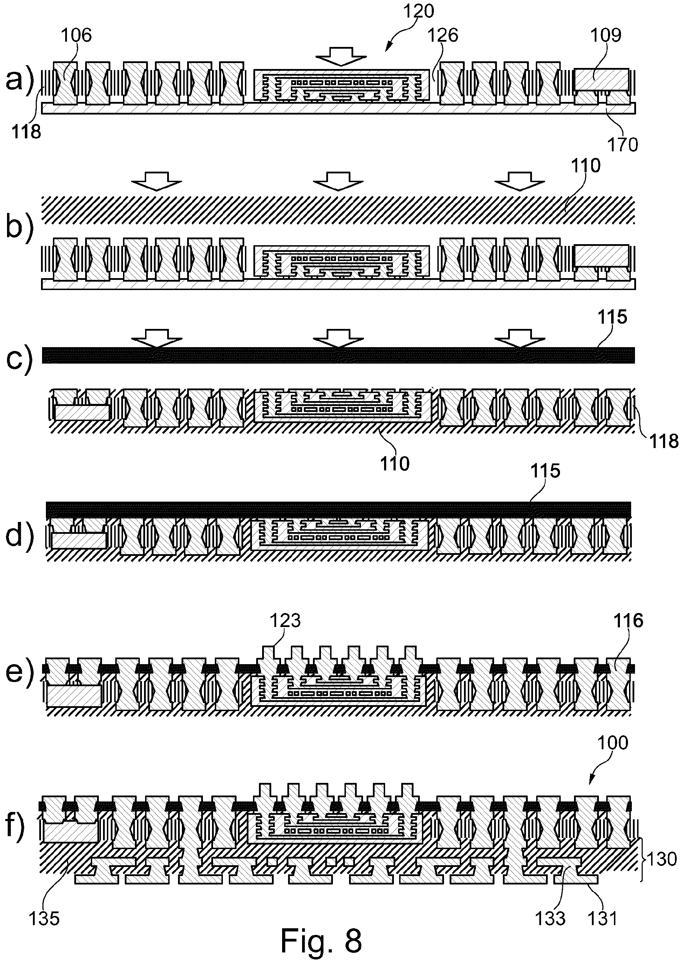

**Figures 8a to 8f** show a method of manufacturing an IC substrate 100 according to a further exemplary embodiment of the invention.

Figure 8a: there is provided a temporary carrier 170 onto which the bridge element 120 is arranged/formed. The first bridge terminal 121a and the second bridge terminal 121b are oriented towards the temporary carrier 170 and are in direct physical contact with the later. Said terminals 121a, 121b are electrically interconnected via the electric interconnection 125 in the dielectric protection material 122. The bridge element 120 is placed in a cavity 126 of a further core layer structure 118 (e.g. a prepreg) that is also arranged on the temporary carrier 170. A plurality of hourglass-shaped vias 106 is formed through the further core layer structure 118. Additionally, a further component 109 is embedded in the further core layer structure 118.

Figure 8b: the reinforced fiber-free dielectric material 110 is provided (in uncured form) on top of the bridge element 120 and the further core layer structure 118. The reinforced fiber-free dielectric material 110 fills the part of the cavity 126, which is not occupied by the bridge element 120, and thereby encapsulates the bridge element 120.

Figure 8c and 8d: the encapsulated bridge element 120 and the further core layer structure 118 are removed from the temporary carrier 170 (and turned around in this example) and are covered (laminated) by an upper dielectric layer structure 115 that is arranged on top of the terminals 121a, 121b and the plurality of hourglass-shaped vias 116. The fiber-free dielectric material 110 is flush with the first bridge terminal 121a and the second bridge terminal 121b of the bridge element 120 on the upper main surface.

Figure 8e: the first bridge terminal 121a and the second bridge terminal 121b are electrically connected through the upper dielectric layer structure 115 by a plurality of bridge element vias 123. Further, the vias 105 are respectively electrically connected through the upper dielectric layer structure 115 by a plurality of upper dielectric layer structure vias 116.

Figure 8f: a redistribution layer structure 130, comprising a plurality of traces 131 and vias 133 in a dielectric material 135 (being similar to the dielectric protection material 122), is formed at the bottom of the IC substrate 100, directly below the reinforced fiber-free dielectric material 110 and the further core layer structure 118. The final IC substrate 100 is comparable with the one described for Figure 4.

### Reference signs

- 100: IC substrate
- 101: First main surface
- 102: Second main surface
- 103: Core layer structure
- 105: Further electric interconnections, via
- 106: Hourglass-shaped via
- 108: Further component
- 109: Embedded component
- 110: Reinforced fiber-free dielectric material
- 115: Upper dielectric layer structure
- 116: Upper dielectric layer structure via
- 118: Further core layer structure, prepreg
- 120: Bridge element
- 121a: First bridge terminal
- 121b: Second bridge terminal
- 122: Dielectric protection material
- 123: Bridge element via
- 125: Electric interconnection
- 126: Cavity
- 130: Redistribution layer structure, RDL
- 131: RDL pad
- 132: RDL solder ball
- 133: RDL via
- 135: RDL dielectric material
- 136: Further RDL dielectric material, reinforced fiber-free material
- 140a: First component
- 140b: Second component
- 141: Component terminal
- 142: Component solder ball
- 143: Component bridge terminal
- 144: Component bridge solder ball
- 150: IC substrate arrangement
- 170: Temporary carrier
- 200: Electronic assembly
- 250: Component carrier

## Claims

1. An integrated circuit, IC, substrate (100), comprising:
a reinforced fiber-free dielectric material (110);
a bridge element (120) comprising:
at least two electrically conductive terminals (121a, 121b),
an electrical interconnection (125) that electrically interconnects the at least two electrically conductive terminals (121a, 121b), and
a dielectric protection material (122) that encapsulates the electrical interconnection (125),
wherein the bridge element (120) is embedded in the reinforced fiber-free dielectric material (110), so that at least two components (140a, 140b), in particular active and/or passive components, when surface mounted to a first main surface (101) of the IC substrate (100), are electrically connectable to the at least two electrically conductive terminals (121a, 121b), respectively; and
a redistribution layer, RDL, structure (130), arranged at a second main surface (102) of the IC substrate (100) being opposite to the first main surface (101), and electrically connectable by further electrical interconnections (105) to the at least two components (140a, 140b).

2. The IC substrate (100) according to claim 1,
wherein the reinforced fiber-free dielectric material (110) is reinforced by a spheric material, in particular glass spheres or carbon spheres, more in particular wherein the dielectric material (100) comprises an Ajinomoto build-up film, ABF.

3. The IC substrate (100) according to claim 1 or 2,
wherein the bridge element (120), in particular the IC substrate (100) itself besides embedded components (109), is free of silicon.

4. The IC substrate (100) according to any one of the preceding claims,
wherein the dielectric protection material (122) is an organic material, in particular wherein the dielectric protection material (122) is different to the reinforced fiber-free dielectric material (110),
more in particular wherein the dielectric protection material (122) comprises a non-reinforced resin,
more in particular wherein the dielectric protection material (122) comprises at least one of a photo-imaginable dielectric, PID, material and polyimide.

5. The IC substrate (100) according to any one of the preceding claims, further comprising:
a core layer structure (103) in which the bridge element (120) is at least partially embedded,
in particular
wherein the dielectric material (110) forms the core layer structure (103),
and/or
wherein the dielectric material (110) is provided in the core layer structure (103), in particular a fiber-enforced dielectric material (118),
and/or
wherein the further electrical interconnections (105) are configured as a plurality of vias that at least partially vertically extend through the IC substrate (100) and that are electrically connectable to the components (140a, 140b) and/or the redistribution layer structure (130),
in particular wherein the bridge element (120) is arranged in between the plurality of vias (105) in a horizontal direction (x, y).

6. The IC substrate (100) according to claim 5,
wherein the thickness of the core layer structure (103) is larger than the thickness of the bridge element (120).

7. The IC substrate (100) according to any one of the preceding claims, further comprising:
an upper dielectric layer structure (115) on top of the bridge element (120) and the reinforced fiber-free dielectric material (110),
wherein in particular the upper dielectric layer structure (115) comprises a different material as the reinforced fiber-free dielectric material (110),
in particular wherein the upper dielectric layer structure (115) comprises a plurality of upper dielectric layer structure vias (116) that vertically extend through the upper dielectric layer structure (115) and that are electrically connectable to the components (140a, 140b) and/or are electrically connected to the further electrical interconnections (105).

8. The IC substrate (100) according to any one of the preceding claims, wherein the redistribution layer structure (103) comprises an RDL dielectric material (136) that is different from the dielectric material (110), in particular a fiber-reinforced dielectric material (135).

9. An IC substrate arrangement (150) comprising:
the IC substrate (100) according to any one of the preceding claims; and
the at least two components (140a, 140b) surface mounted to the first main surface (101);
wherein the first component (140a) is electrically connected to the first terminal (121a) of the bridge element (120), and
wherein a second component (140b) is electrically connected to the second terminal (121b) of the bridge element (120),
so that the at least two components (140a, 140b) are electrically interconnected by the bridge element (120).

10. An electronic assembly (200) comprising:
the IC substrate (100) according to any one of the claims 1 to 8; or
the IC substrate arrangement (150) according to claim 9; and
a component carrier (250), in particular a printed circuit board or a further IC substrate,
wherein the IC substrate (100) or the IC substrate arrangement (150) is surface mounted to the component carrier (250).

11. A method of manufacturing an integrated circuit, IC, substrate (100), the method comprising:
providing a bridge element (120) that comprises at least two electrically conductive terminals (121a, 121b), an electrical interconnection (125) that electrically interconnects the at least two electrically conductive terminals (121a, 121b), and a dielectric protection material (122) that encapsulates the electrical interconnection (125);
embedding the bridge element (120) at least partially in a reinforced fiber-free dielectric material (110), so that at least two components (140a, 140b), when surface mounted to a first main surface (101) of the IC substrate (100), are electrically connectable to the at least two electrically conductive terminals (121a, 121b), respectively; and
forming a redistribution layer structure (130) at a second main surface (102) of the IC substrate (100) being opposite to the first main surface (101), and electrically connectable to the at least two components (140a, 140b).

12. The method according to claim 11, wherein providing the bridge element (120) further comprises:
placing the bridge element (120), in particular with a terminal main surface where the terminals (121a, 121b) are exposed, on a temporary carrier (170).

13. The method according to claim 11 or 12, wherein embedding the bridge element (120) further comprises:
laminating the dielectric material (110) over the bridge element (120), or
placing the bridge element (120) in a cavity (126) of a core layer structure (103, 118) and encapsulating the bridge element (120) in the cavity (126) with the reinforced fiber-free dielectric material (110).

14. The method according to any one of claims 11 to 13, further comprising:
forming a plurality of further electric interconnections (105) through the reinforced fiber-free dielectric material (110) and/or the core layer structure (103, 118), and/or
forming an upper dielectric layer structure (115) on top of the reinforced fiber-free dielectric material (110) and particularly forming a plurality of upper dielectric layer structure vias (116) through said upper dielectric layer structure (115) .

15. Using an organic bridge element (120) in a silicon-free IC substrate (100), wherein the organic bridge element (120) is embedded in a reinforced fiber-free dielectric material (110).
